(19)

Europäisches Patentamt
European Patent Office
Office européen des brevets

(11) **EP 4 175 113 A1**

(12) **EUROPEAN PATENT APPLICATION**
published in accordance with Art. 153(4) EPC

(43) Date of publication:
**03.05.2023 Bulletin 2023/18**

(21) Application number: **21834259.0**

(22) Date of filing: **30.06.2021**

(51) International Patent Classification (IPC):
**H02J 7/00** *(2006.01)*

(52) Cooperative Patent Classification (CPC):
**H02J 7/00**

(86) International application number:
**PCT/CN2021/103509**

(87) International publication number:
**WO 2022/002121 (06.01.2022 Gazette 2022/01)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **30.06.2020 CN 202021264961 U**

(71) Applicant: **BYD Company Limited
Shenzhen, Guangdong 518118 (CN)**

(72) Inventors:
- **CAO, Hu
  Shenzhen, Guangdong 518118 (CN)**
- **YIN, Shaowen
  Shenzhen, Guangdong 518118 (CN)**
- **YIN, Xueqin
  Shenzhen, Guangdong 518118 (CN)**
- **GUANG, Hongyan
  Shenzhen, Guangdong 518118 (CN)**

(74) Representative: **DehnsGermany Partnerschaft
von Patentanwälten
Theresienstraße 6-8
80333 München (DE)**

(54) **CHARGING AND DISCHARGING SYSTEM**

(57) The present disclosure discloses a charging and discharging system. The charging and discharging system includes multiple battery packs and at least one voltage equalization module. The multiple battery packs are connected in parallel. Each of a subset of the battery packs is connected in series with the at least one voltage equalization module. The at least one voltage equalization module is configured to adjust, to a target voltage, an output voltage of the corresponding battery pack and the at least one voltage equalization module that are connected in series. The energy storage system according to the embodiments of the present disclosure can effectively resolve the problem regarding circulating currents of batteries connected in parallel, and has low costs and a small volume and weight.

FIG. 3

EP 4 175 113 A1

**Description**

**CROSS-REFERENCE TO RELATED APPLICATIONS**

This application claims priority to and benefits of Chinese Patent Application No. 202021264961.0, filed "CHARGING AND DISCHARGING SYSTEM" on June 30, 2020. The entire content of the above-referenced applications is incorporated herein by reference.

**FIELD**

The present disclosure relates to the technical field of batteries, and more specifically, to a charging and discharging system.

**BACKGROUND**

With the rapid development of the lithium battery and the lithium battery energy storage technology, increasingly more lithium battery energy storage applications emerge. Lithium battery packs are generally realized by battery cores connected in series and parallel. The lithium battery packs used in an energy storage system are generally realized by series or parallel connection of lithium battery packs in order to obtain a larger capacity.

In the related art, with the extension of the operating time of the energy storage system, battery packs connected in parallel gradually vary. Adding or replacing battery packs will cause internal circulating currents due to voltage differences of the battery packs. On the one hand, the effective capacity of the energy storage system is reduced, and on the other hand, the battery of the energy storage system is further unbalanced and the performance is degraded or damaged.

In the related art, the direct parallel connection of lithium battery packs is generally realized by increasing the current protection value. However, the above method has the following disadvantages. First, it is necessary to ensure that the voltage difference of the lithium battery packs to be connected in parallel is as small as possible. If the voltage difference is too large, an inrush current during parallel connection may be greater than a set overcurrent protection value, resulting in the failure of parallel connection. Second, a large circulating current still exists between the lithium battery packs connected in parallel, and the risk of damaging the lithium battery packs is very high. Third, if there are a large number of battery core packs in the lithium battery packs, the wiring is inconsistent, the battery impedance is inconsistent, and the battery consistency is poor, which may also generate a large circulating current that will damage the battery.

In the related art, the direct parallel connection of lithium battery packs is also realized by connecting equalization modules in parallel. However, the power of the equalization module is excessively high due to the direct parallel connection of the equalization modules. Therefore, in order to meet the requirement of directly connecting the lithium battery packs in parallel, a high-power equalization module is selected, which may lead to high costs of the entire energy storage system and a large volume and weight of the energy storage system, and therefore is inconvenient to use.

**SUMMARY**

The present disclosure is intended to resolve at least one of technical problems existing in the related art. An object of the present disclosure is to provide a charging and discharging system, which can realize safe parallel connection of battery packs and can effectively resolve the problem regarding circulating currents of batteries connected in parallel, and has low costs and a small volume and weight.

In order to achieve the above object, according to an embodiment of the present disclosure, a charging and discharging system is provided. The charging and discharging system includes: multiple battery packs connected in parallel; and at least one voltage equalization module, where each of a subset of the battery packs is connected in series with the at least one voltage equalization module. The at least one voltage equalization module is configured to adjust, to a target voltage, an output voltage of the corresponding battery pack and the at least one voltage equalization module that are connected in series.

In some embodiments, the voltage equalization module is a boost-buck equalization module. The boost-buck equalization module is connected in series with the battery pack, and is configured to increase or decrease, to the target voltage, an output voltage of the battery pack and the boost-buck equalization module that are connected in series.

In some embodiments, the boost-buck equalization module includes a boost-buck regulation unit. The boost-buck regulation unit further includes:

a first conversion subunit, configured to convert a direct current (DC) supply signal to an alternating current (AC) signal;
a transformer subunit, including a primary side coil and a secondary side coil, where the primary side coil of the transformer subunit is connected with an output terminal of the first conversion subunit, and is configured to transmit the AC signal;
a second conversion subunit, where an input terminal of the second conversion subunit is connected with the secondary side coil of the transformer subunit, and is configured to convert the AC signal to a first DC signal, and a voltage value of the first DC signal is equal to an absolute value of a voltage difference between the target voltage and the output voltage of the battery pack; and
a third conversion subunit, where an input terminal of the third conversion subunit is connected with an output terminal of the second conversion subunit, the third conversion subunit is configured to convert the first DC signal to a second DC signal, an output terminal of the third conversion subunit outputs the second DC signal, and a voltage value of the second DC signal is equal to a voltage value of the first DC signal, or the voltage value of the second DC signal is a negative value of the voltage value of the first DC signal.

In some embodiments, the voltage equalization module is a boost equalization module. The boost equalization module is connected in series with the battery pack, and is configured to increase, to the target voltage, an output voltage of the battery pack and the boost equalization module that are connected in series.
In some embodiments, the voltage equalization module is a buck equalization module. The buck equalization module is connected in series with the battery pack, and is configured to decrease, to the target voltage, an output voltage of the battery pack and the buck equalization module that are connected in series.
In some embodiments, the charging and discharging system further includes at least one external power supply module. The at least one external power supply module is connected with the at least one voltage equalization module, and is configured to provide a DC supply signal for the voltage equalization module.
In some embodiments, the battery pack is connected in parallel to a busbar.
In some embodiments, N battery packs are arranged, and N voltage equalization modules are arranged. The N battery packs are connected in series with the N voltage equalization modules in a one-to-one correspondence, so that the output voltage of each of the battery packs and each of the voltage equalization modules that are connected in series is equal to the target voltage. The target voltage is a busbar voltage.
In some embodiments, N battery packs are arranged, and N-1 voltage equalization modules are arranged. The N-1 battery packs are connected in series with the N-1 voltage equalization modules in a one-to-one correspondence, so that the output voltage of each of the battery packs and a corresponding one of the voltage equalization modules that are connected in series is equal to the target voltage. The target voltage is equal to the output voltage of the battery pack that is not connected in series with the voltage equalization module.
In some embodiments, the voltage equalization module includes: a voltage regulation unit, being a boost-buck regulation unit, a boost regulation unit, or a buck regulation unit; a communication unit, connected with battery management units of the multiple battery packs, and configured to acquire battery parameters of each of the battery packs; a current detection unit, configured to detect an output current of the voltage equalization unit; a voltage detection unit, configured to detect an output voltage of the voltage equalization unit; and a control unit, respectively connected with the communication unit, the current detection unit, and the voltage detection unit, and configured to control the voltage regulation unit according to the battery parameters, the output current, and the output voltage, so that the output voltage of the battery pack and the voltage equalization module that are connected in series is equal to the target voltage.
In some embodiments, the charging and discharging system further includes multiple switch modules. The switch modules are connected in series with the voltage equalization modules in a one-to-one correspondence.
Beneficial effects of the present disclosure are as follows. According to the charging and discharging system of the embodiment of the present disclosure, at least one voltage equalization module is arranged. Each of a subset of the battery packs is connected in series with the at least one voltage equalization module. The at least one voltage equalization module is configured to adjust, to the target voltage, the output voltage of the corresponding battery pack and the at least one voltage equalization module that are connected in series, that is, the output voltage of the battery pack and the voltage equalization module that are connected in series is equal to the target voltage. In this way, the voltage difference between the battery packs can be reduced, the inrush current during the parallel connection can be reduced, safe parallel connection is realized, and the voltage difference between the battery packs is relatively small, so as to avoid the formation of circulating currents between the battery packs connected in parallel, thereby effectively resolving the problem regarding circulating currents of batteries connected in parallel, improving the reliability and stability of the system, and increasing the life of the system. In addition, compared with the solution of the existing parallel equalization module, since the voltage equalization module and the battery pack in the embodiment of the present disclosure are connected in series, the output voltage of the equalization module is the difference between the target voltage and the output voltage of the battery pack, and the difference is very small compared with an output voltage of a branch where the battery pack is located. Therefore, the present disclosure can further reduce the power of the voltage equalization module, thereby reducing the cost and the volume and weight of the energy storage system, which facilitates mass application and mounting.

The additional aspects and advantages of the present disclosure will be provided in the following description, some of which will become apparent from the following description or may be learned from practices of the present disclosure.

## BRIEF DESCRIPTION OF THE DRAWINGS

The foregoing and/or additional aspects and advantages of the present disclosure will become apparent and comprehensible in the embodiment description made with reference to the following accompanying drawings, where:

FIG. 1 is a schematic structural diagram of an energy storage system in the related art.
FIG. 2 is a schematic diagram of a solution of an energy storage system that has the problem of high power of a DC/DC module in the related art.
FIG. 3 is a schematic structural diagram of an embodiment of a charging and discharging system according to the present disclosure.
FIG. 4 is a schematic structural diagram of a battery pack connected with a voltage equalization module according to an embodiment of a charging and discharging system of the present disclosure.
FIG. 5 is a circuit diagram of a bidirectional DC/DC power conversion unit according to an embodiment of a charging and discharging system of the present disclosure.
FIG. 6 is a schematic diagram of a charging and discharging system according to an embodiment of the present disclosure.
FIG. 7 is a schematic diagram according to an embodiment of the present disclosure.
FIG. 8 is a schematic diagram of a charging and discharging system according to an embodiment of the present disclosure.
FIG. 9 is a schematic diagram of a charging and discharging system according to an embodiment of the present disclosure.
FIG. 10 is a schematic diagram of a charging and discharging system according to an embodiment of the present disclosure.

Reference numerals:

Related art:
Energy storage system 1', battery pack 10', battery core 11', DC/DC converter 20',

The present disclosure:

Charging and discharging system 1,
busbar 10, positive busbar 11, negative busbar 12,
battery pack 20, battery management system 21, voltage equalization module 30, switch 40, external power supply module 311,
communication unit 36, voltage acquisition module 37, current acquisition module 38, and control unit 39.

## DETAILED DESCRIPTION

The embodiments of the present disclosure are described below in detail. Examples of the embodiments are shown in the accompanying drawings, and same or similar reference signs in all the accompanying drawings indicate same or similar components or components having same or similar functions. The embodiments described below with reference to the accompanying drawings are exemplary, and are intended to explain the present disclosure and cannot be construed as a limitation to the present disclosure.

In the description of the present disclosure, " multiple " means two or more than two.

The present disclosure is provided by the author of the present disclosure based on the discovery and recognition of the following facts and problems.

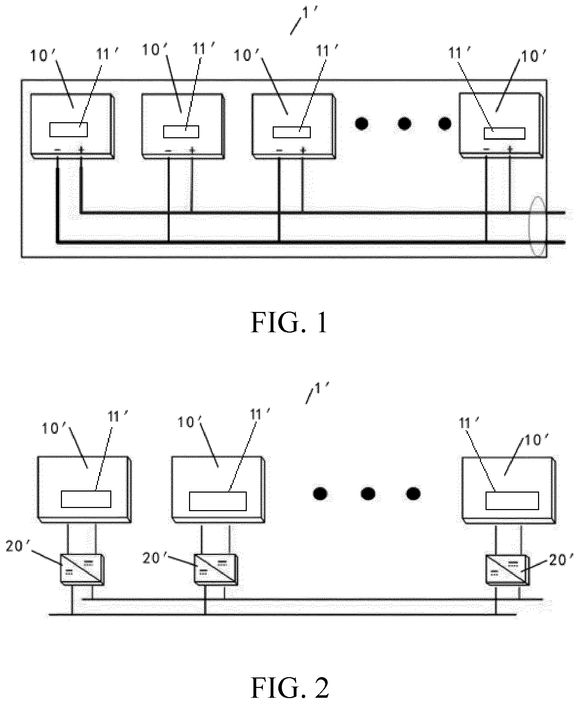

In the related art, in order to realize the parallel connection of battery packs, for example, the solution 1 shown in FIG. 1, the direct parallel connection is realized by increasing the current protection value. When battery packs 10' are connected in parallel, two battery packs 10' are used as an example. The generated inrush current

$$Ipk = \cfrac{Vpack1 - Vpack2}{N1*(R1+R2)+N2*(R1+R2)}$$

. Vpack1 and Vpack2 are respectively voltages of the two battery packs 10', and N1 and N2 are respectively quantities of battery cores 11' inside the battery packs 10'. A battery core parasitic resistance R1 and a welding resistance R2 are generally controlled to be relatively small. Therefore, if a voltage difference between the two battery packs 10' is not too large, the peak current during parallel connection can be controlled within a certain range, and direct parallel connection can be performed as long as overcurrent protection of a battery management system (BMS) of the battery packs 10' is not triggered.

For example, the battery packs 10' are composed of 16 battery cores 11' connected in series. Due to the use and the initial states of the battery packs 10', it is assumed that a voltage of a battery pack 10' is 54 V, and a voltage of an other battery pack 10' is 48 V By laser welding, the internal resistance of the battery core 11' is 1 m'Ω, the welding resistance is 1 m'Ω, and then through calculation, a peak current in parallel connection Ipk =

$$\cfrac{54V - 48V}{16*(1+1)*10^{-3}+16*(1+1)*10^{-3}} = 93.75 \text{ A}$$

. Therefore, the peak protection current is set to be greater than 93.75 A, so as to realize direct parallel connection without triggering overcurrent protection, and achieve success in the parallel connection. When the parallel connection succeeds, the self-equilibrium of the battery pack 10' is realized through self-discharge.

For the disadvantages existing in the above solution 1, in order to resolve the problem of safe parallel connection, a solution 2 shown in FIG. 2 is provided in the related art, in which a bidirectional DC/DC converter 20' is added to an output terminal of each battery pack 10'. However, the solution 2 has disadvantages of high costs, a large volume and high power of the DC/DC converter, which is inconvenient to use.

In consideration of the situation in the related art, the present disclosure provides a charging and discharging system, which can resolve the problems of safe parallel connection and circulating currents of batteries.

A charging and discharging system according to an embodiment of the present disclosure is described below with reference to the accompanying drawings.

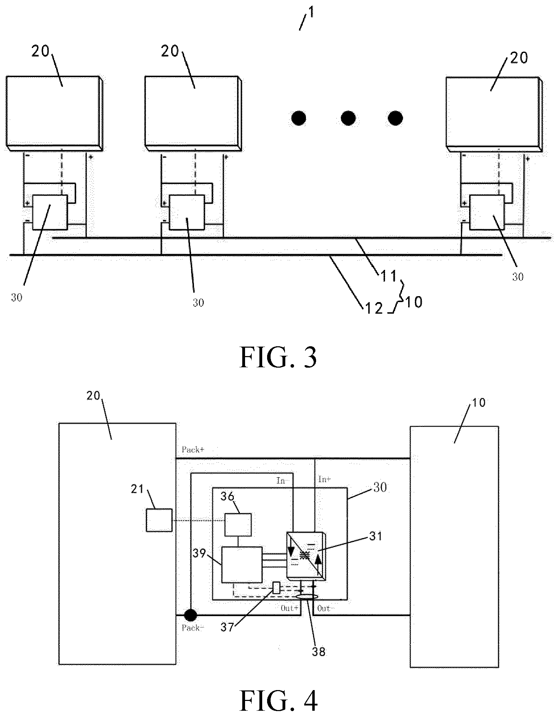

As shown in FIG. 3, the charging and discharging system 1 according to the embodiment of the present disclosure includes multiple battery packs 20 and at least one voltage equalization module 30.

The multiple battery packs 20 are connected in parallel. Each of the battery packs 20 includes multiple battery cores. The multiple battery cores are connected in series or in parallel to form a battery pack. The battery cores may be lithium batteries, or the like.

Each of a subset of the battery packs 20 is connected in series with the at least one voltage equalization module 30. In an embodiment, the subset of the battery packs may include all of the multiple battery packs 20 or may be part of the multiple battery packs 20. In the embodiment, each of the subset of the battery packs 20 may be connected in series with one voltage equalization module, or each of the subset of the battery packs 20 may be connected in series with multiple voltage equalization modules. Further, each of the subset of the battery packs may be connected in series with a boost-buck module or a boost module or a buck module. Alternatively, after the battery pack is connected with a boost module in series, the boost module is connected in series with the buck module, and the buck module is connected to a busbar. Alternatively, after the battery pack is connected with a buck module in series, the buck module is connected in series with the boost module, and then the boost module is connected to a busbar.

In an embodiment, the at least one voltage equalization module 30 is configured to adjust, to a target voltage, an output voltage of the corresponding battery pack and the at least one voltage equalization module 30 that are connected in series. That is to say, the output voltages of the battery packs 20 and the voltage equalization modules 30 that are connected in series are all equal to the target voltage, that is, the voltage of the voltage equalization module 30 is a voltage difference between the target voltage and a voltage of the battery pack. In the embodiment, the target voltage may be a preset busbar voltage, and the busbar voltage is a voltage value within a busbar voltage error range. The busbar voltage error range is based on the busbar voltage. The busbar voltage error range means that in practical application, subject to the impact of the adjustment accuracy, the target voltage can only be infinitely close to the busbar voltage and cannot be absolutely equal to the busbar voltage value. For example, in this embodiment, a value of the preset busbar voltage is 600 V, and the target voltage can be within the range of 600 V ± 1 V Alternatively, the target voltage may also be within the range of the output voltages of the battery packs that are not connected in series with the voltage equalization modules 30, so that the output voltages of the multiple battery packs 20 connected in parallel can be closer to each other. The voltage difference between the battery packs 20 connected in parallel can be reduced, and an inrush current during the parallel connection is reduced, so as to avoid the formation of circulating currents between the battery packs 20 connected in parallel, thereby realizing the safe parallel connection.

According to the charging and discharging system 1 of the embodiment of the present disclosure, the voltage equalization module 30 is arranged for the battery packs. That is to say, each of the subset of the battery packs is connected in series with at least one voltage equalization module. The at least one voltage equalization module 30 is configured to adjust, to the target voltage, the output voltage of the corresponding battery pack and the at least one voltage equalization module 30 that are connected in series, that is, the output voltage of the battery pack and the voltage equalization module that are connected in series is equal to the target voltage. In this way, the voltage difference between the battery packs can be reduced, the inrush current during the parallel connection can be reduced, safe parallel connection is realized, and the voltage difference between the battery packs is relatively small, so as to avoid the formation of circulating currents between the battery packs connected in parallel, thereby effectively resolving the problem regarding circulating currents of batteries connected in parallel, improving the reliability and stability of the system, and increasing the life of the system. In addition, compared with the solution of the existing bidirectional DC/DC converter, since the voltage equalization module 30 and the battery pack 20 in the embodiment of the present disclosure are connected in series, the output voltage of the equalization module 30 is the difference between the target voltage and the voltage of the battery pack 20, and the difference is very small compared with an output voltage of a branch where the battery pack 20 is located. Therefore, the present disclosure can further reduce the power of the voltage equalization module 30. In a specific embodiment, compared with the solution 2 in the related art, the charging and discharging system 1 of the embodiment of the present disclosure can reduce the power of the voltage equalization module from original 150 KW of the DC/DC module to 1.25 KW, that is, the power is reduced to 0.8% of the original power. Therefore, the voltage equalization module 30 of the embodiment of the present disclosure can have a smaller volume and lower costs, so as to facilitate mass application and mounting.

In the embodiment, the voltage equalization module 30 may be connected in series with a positive electrode of a main circuit, or may be connected in series with a negative electrode of the main circuit. FIG. 4 is a schematic diagram of the voltage equalization module 30 connected in series with the negative electrode of the battery pack. A positive input terminal of the voltage equalization module is connected with the positive electrode of the battery pack 20, and a negative input terminal of the voltage equalization module is connected with a negative electrode of the battery pack 20. A positive output terminal of the voltage equalization module is connected in series with the negative electrode of the battery pack 20, and a negative output terminal of the voltage equalization module is an external negative electrode of the battery system.

In some embodiments, the voltage equalization module 30 may be a boost-buck equalization module. The boost-buck equalization module is connected in series with the battery pack 20, and is configured to increase or decrease, to the target voltage, an output voltage of the battery pack 20 and the boost-buck equalization module that are connected in series. The above boost-buck equalization module may be unidirectionally adjusted for the output voltage of the battery pack branch. In other words, the output voltage of the battery pack branch where the boost-buck equalization module is located may be increased or decreased by the boost-buck equalization module, so that the output voltages of all of the battery pack branches connected in parallel achieve equalization, and the voltage difference is reduced to avoid the formation of a circulating current between the branches of the battery packs 20, so as to achieve the equalization. The target voltage may be the busbar voltage within the busbar voltage range or within the busbar voltage error range or the output voltage of the battery pack that is not connected with the voltage equalization module 30. The busbar voltage within the busbar voltage range may be equal to the busbar voltage value at the current moment and within the busbar voltage error range.

In some other embodiments, the voltage equalization module 30 may be a boost equalization module. The boost equalization module is connected in series with the battery pack, and is configured to increase, to the target voltage, an output voltage of the battery pack and the boost equalization module that are connected in series. The boost equalization module includes a boost regulation unit. In some other embodiments, the voltage equalization module 30 may be a buck equalization module. The buck equalization module is connected in series with the battery pack, and is configured to decrease, to the target voltage, an output voltage of the battery pack and the buck equalization module that are connected in series. The buck equalization module includes a buck regulation unit.

For example, for the parallel connection of battery packs 20 composed of old and new battery packs connected in parallel, the output voltages of some battery packs 20 are relatively low, while the output voltages of some battery packs 20 are relatively high. In order to meet the equalization requirements, the buck equalization module or the boost equalization module may be selected in a targeted manner to be connected with the corresponding battery pack 20 in series to achieve the purpose of voltage equalization, so that the output voltage value after the series connection can be within the target voltage range.

In the embodiment, the boost-buck equalization module, or the boost equalization module, or the buck equalization module may be selected for series connection according to the specific situations of the battery packs connected in parallel, or a combination of the boost module or the buck module is selected to be connected in series with the battery pack, so as to achieve the equalization of the output voltage of the branch where the battery packs connected in parallel are located, thereby avoiding the formation of the circulating current.

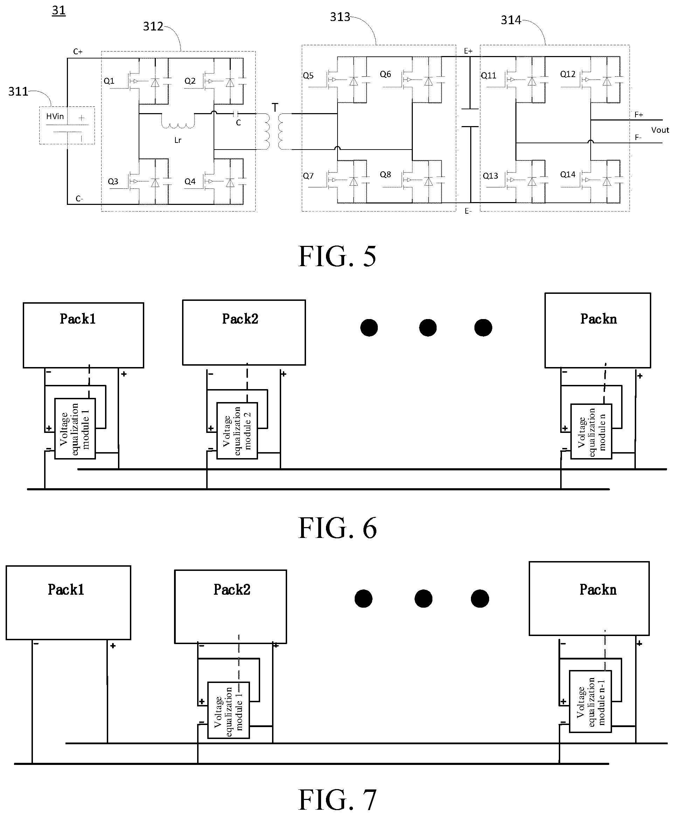

Further, in the embodiment, as shown in FIG. 4, the boost-buck equalization module includes a boost-buck regulation unit 31. As shown in FIG. 5, the boost-buck regulation unit 31 further includes a first conversion subunit 312, a transformer subunit T, a second conversion subunit 313, and a third conversion subunit 314.

The first conversion subunit 312 is configured to convert a direct current (DC) supply signal to an alternating current (AC) signal. The transformer subunit T includes a primary side coil and a secondary side coil. The primary side coil of the transformer subunit T is connected with an output terminal of the first conversion subunit 312, and is configured to transmit the AC signal. An input terminal of the second conversion subunit 313 is connected with the secondary side coil of the transformer subunit T, and is configured to convert the AC signal to a first DC signal. A voltage value of the first DC signal is equal to an absolute value of a voltage difference between the target voltage and the output voltage of the battery pack. An input terminal of the third conversion subunit 314 is connected with an output terminal of the second conversion subunit 313. The third conversion subunit 314 is configured to convert the first DC signal to a second DC signal. An output terminal of the third conversion subunit 314 outputs the second DC signal. A voltage value of the second DC signal is equal to a voltage value of the first DC signal, so as to achieve boosting, or the voltage value of the second DC signal is a negative value of the voltage value of the first DC signal, so as to achieve voltage reduction.

In some embodiments, the first conversion subunit 312, the transformer subunit T, and the second conversion subunit 313 can take the form of a bidirectional DC/DC power conversion unit and may be combined with the third conversion subunit 314 to realize boost and buck. The bidirectional DC/DC power conversion unit is equally applicable to charging and discharging of the power supply. Different from the common bidirectional DC/DC power conversion unit, the boost-buck equalization module of the embodiment of the present disclosure can realize boosting and bucking of a unidirectional input by adding the third conversion unit 314.

In the embodiment, the bidirectional DC/DC power conversion unit can be implemented by using various topology schemes. FIG. 5 shows a circuit diagram of a DC/DC topology scheme, that is, a phase-shifted full-bridge DC/DC converter topology. This topology is just an example to illustrate the completeness of the entire system solution, and therefore should not be construed as a limitation on the scope of the patent of the present disclosure, and other DC/DC topologies also fall within the protection scope of the present disclosure.

The boost-buck equalization module shown in FIG. 5 is used as an example. The composition and connection of the first conversion subunit 312, the second conversion subunit 313, and the third conversion subunit 314 are shown in the figure. The modulation principle of the first conversion unit 312 and the second conversion unit 313 is that Q1 and Q3 are controlled to be closed complementarily, Q2 and Q4 are controlled to be closed complementarily, and they all have a duty cycle of 50%. A modulation signal for a low-voltage side switch transistor of the transformer subunit T and a modulation signal for a high-voltage side switch transistor have a same sequence (Q5 and Q7 are closed complementarily, Q7 and Q8 are closed complementarily, and they all have a duty cycle of 50%), but differ from each other by an angle. By changing the angle difference of the modulation signals on the high and low voltage sides, the output voltage regulation function and the battery charging or battery discharging function are realized. The bidirectional DC/DC power conversion unit can adjust the current direction through the on/off of the switch transistor of the third conversion subunit 314 in the second half to output a positive voltage or a negative voltage. Transforming and controlling the output voltage of the bidirectional DC/DC power conversion unit can directly output the output voltage of the bidirectional DC/DC power conversion unit (specified as a positive voltage) or convert the bidirectional DC/DC power conversion unit to a negative voltage for output.

As shown in FIG. 5, the input terminal of the third conversion subunit 314 is connected with the output of the second conversion subunit 313, the first output terminal of the third conversion subunit 314 is connected with the battery pack, and the second output terminal of the third conversion subunit 314 is connected with the busbar. The third conversion subunit 314 includes switch transistors Q11, Q12, Q13, and Q14. It is assumed that E+ is a positive electrode of an input power supply, E- is a negative electrode of the input power supply, F+ is a positive electrode of an output power supply, and F- is a negative electrode of the output power supply. When the output voltage of the third conversion subunit 314 is required to be a positive voltage, Q12 and Q13 are controlled to be closed simultaneously, then F+ and E+ have the same potential, and F- and E- have the same potential, that is, the output voltage is the same as the input voltage, which is a positive voltage, so as to realize the function of boosting. When the output voltage of the third conversion subunit 314 is required to be a negative voltage, Q11 and Q14 are controlled to be closed simultaneously, then F+ and E- have the same potential, and F- and E+ have the same potential, that is, the output voltage is the opposite to the input voltage, which is a negative voltage, so as to realize the function of bucking.

In some embodiments, as shown in FIG. 4, the voltage equalization module 30 includes a voltage regulation unit 31, a communication unit 36, a current detection unit 38, a voltage detection unit 37, and a control unit 39.

The voltage regulation unit 31 may have a unidirectional function, for example, a function of achieving bucking alone or boosting alone. That is to say, boosting or bucking can only be performed in one way. For example, the topology of the boost regulation unit or the buck regulation unit may adopt a general bidirectional DC/DC module. Alternatively, the voltage regulation unit 31 may also realize both boosting and bucking in the same direction, for example, the boost-buck voltage regulation unit above. That is to say, the voltage regulation unit 31 may be a boost-buck regulation unit, a boost regulation unit, or a buck regulation unit. The communication unit 36 is connected with battery management units of the multiple battery packs 20, and configured to acquire battery parameters of each of the battery packs. The current detection unit 38 is configured to detect an output current of the voltage regulation unit 31. The voltage detection unit 37 is configured to detect an output voltage of the voltage regulation unit. The control unit 39 is respectively connected with the communication unit 36, the current detection unit 38, and the voltage detection unit 37, and configured to control the voltage regulation unit 31 according to the battery parameters, the output current, and the output voltage, so that the output voltage of each of the battery packs 20 and the voltage equalization module 30 that are connected in series is equal to the target voltage. For example, the control unit 39 may be a device such as a control chip, a DSP, a single-chip microcomputer, or the like. The control unit 39 communicates with the battery management unit 21 of the battery pack 20 through the communication module 36. For example, the communication may be realized by RS485, RS232, CAN, and the like. The information obtained from the battery pack 20 includes, for example, a voltage, a current, a temperature, a capacity, and alarm information of the battery pack. The operation of the voltage regulation unit 31 is controlled according to these parameters of the battery packs 20, for example, voltage regulation coefficients of the voltage regulation unit, to achieve the boosting or bucking. Alternatively, when alarm information is detected, the voltage regulation unit 31 is controlled to stop, or the like. The voltage regulation unit 31 is monitored to output a current and a voltage, so as to form closed-loop control more accurately, so that the output voltage of the battery pack 20 and the voltage equalization module 30 that are connected in series is within the target voltage range, thereby achieving the purpose of equalization. The voltage difference between the battery packs connected in parallel is reduced, so as to avoid the formation of the circulating current.

In some embodiments, as shown in FIG. 3, the battery pack is connected in parallel to a busbar 10. The busbar includes a positive busbar 11 and a negative busbar 12.

In some embodiments, N battery packs 20 are arranged. The N battery packs 20 are connected in parallel with the busbar 10. N voltage equalization modules 30 are arranged. The number of the battery packs is equal to the number of the N voltage equalization modules 30. The N battery packs 20 are connected in series with the N voltage equalization modules 30 in a one-to-one correspondence, so that the output voltage of each of the battery packs 20 and each of the voltage equalization modules 30 that are connected in series is equal to the target voltage. The target voltage is a busbar voltage. Therefore, the output voltage of each battery pack branch is near the busbar voltage, that is, within the busbar voltage error range, so as to achieve the purpose of equalization. The voltage difference between parallel branches is reduced, so as to avoid the formation of the circulating current between battery packs connected in parallel.

For example, as shown in FIG. 6, the system includes several battery packs Pack1, Pack2, ..., and Packn, and a voltage equalization module 1, ..., and a voltage equalization module n. Each of the battery packs is connected in series with the voltage equalization module 30 and then connected in parallel to the DC busbar. The values of the voltages outputted by the battery packs 20 and the corresponding voltage equalization modules 30 that are connected in series are within an allowable voltage range of the busbar voltage, so as to reduce the voltage difference between the battery packs 20 connected in parallel and eliminate the parallel circulating currents.

In some other embodiments, as shown in FIG. 7, N battery packs are arranged. The N battery packs are connected in parallel with the busbar. N-1 voltage equalization modules are arranged. The N-1 battery packs are connected in series with the N-1 voltage equalization modules in a one-to-one correspondence, so that the output voltage of each of the battery packs and a corresponding one of the voltage equalization modules that are connected in series is equal to the target voltage. The target voltage is equal to an output voltage of the battery pack that is not connected in series with the voltage equalization module. That is to say, the values of the voltages outputted by the battery packs 20 and the corresponding voltage equalization modules 30 that are connected in series are within the range of the output voltages of the battery packs 20 that are not connected with the voltage equalization modules 30, so as to achieve equalization of the voltage between the battery packs 20 connected in parallel. The voltage difference between the battery packs 20 is reduced, so as to eliminate the parallel circulating currents. The above target voltage may also be the busbar voltage, so that the output voltage of each battery pack branch is near the busbar voltage, that is, within the busbar voltage error range, so as to achieve the purpose of equalization. The voltage difference between parallel branches is reduced, so as to avoid the formation of the circulating current between battery packs connected in parallel. A topology of FIG. 6 differs from a topology of FIG. 7 in that the former has one less voltage equalization module than the latter. N battery packs only need N-1 voltage equalization modules to achieve the same function, which is more cost-effective.

Two battery packs are used as an example below. Each of the battery packs is connected in series with a voltage equalization module. For example, voltages of the batteries PACK1 and PACK2 are V1 = 590 V and V2 = 610 V respectively, the battery busbar voltage may be set to 600 V, and the output current is set to 250 A. In order to be consistent with the busbar voltage, the output voltage of the voltage equalization module 30 and the battery PACK1 that are connected in series should be +10 V For example, DC/DC power conversion is performed through the first conversion subunit 312 and the second conversion subunit 313, the voltage of the power supply module is converted to 10 V, then Q12 and Q13 are controlled to be closed simultaneously, and the third conversion unit 314 directly outputs 10 V In this case, the voltage V1 of the battery PACK1 plus the output voltage 10 V of the voltage equalization module 30 is equal to the busbar voltage 600 V, and the output power of the voltage equalization module 30 is P1 = 10 V*250 A = 2500 W.

In order to be consistent with the busbar voltage, the voltage equalization module 30 connected in series with PACK2 outputs -10 V For example, the voltage of the power supply module is converted to 10 V through the first conversion subunit 312 and the second conversion subunit 313, then Q11 and Q14 are controlled to be closed simultaneously, and the third conversion subunit 314 outputs -10 V In this case, the output voltage of the voltage V2 of the battery PACK2 and the voltage equalization module 30 that are connected in series is equal to the busbar voltage, and the output power of the voltage equalization module 30 is P2 = 10 V*250 A = 2500 W. In order to realize reliable parallel connection of two battery packs, the control unit of each voltage equalization module 30, such as an MCU, communicates with the BMS of the battery pack through the communication module 36. The voltage information of the battery pack is collected, such as V1 = 598 V and V2 = 595 V, and an output voltage of 600 V and a current of 100 A are collected through the voltage detection unit 37 and the current detection unit 38. According to the information, the output voltage information and current information are transmitted to the control unit MCU, and the voltage equalization module is controlled to operate, so that each battery pack outputs the same current. Voltage adjustment coefficients of the voltage equalization modules of the battery Pack1 and the battery Pack2 are adjusted to k1 and k2, so that the output voltage of each battery pack can be raised to Vbus.

If the above external conditions remain unchanged, the voltages of the batteries PACK1 and PACK2 are respectively Va1 = 590 V and Va2 = 610 V If the common bidirectional DC/DC module in the related art is used in the solution, the busbar voltage is required to be set to above 610 V (for example, set to 612 V), and the current of 250 Aremains unchanged. For PACK1, the bidirectional DC/DC module outputs +22 V (the voltage of the battery pack is converted to 22 V output voltage through the DC/DC module, the voltage of the battery PACK1 plus the voltage of the bidirectional DC/DC module is equal to the set busbar voltage, and the DC/ The output power of DC control module 1 is P1 = 22 V*250 A = 5500 W). For PACK2, the bidirectional DC/DC module outputs +2 V (the voltage of the battery pack is converted to 2 V output voltage through the DCDC module, the voltage of the battery PACK2 is equal to the set busbar voltage, and the output power of the DC/DC power conversion unit P2 = 2 V*250 A = 500 W). It can be clearly found that for PACK1, the output power of the conventional DC/DC module is nearly twice the output power of the voltage equalization module 30 in the embodiment of the present disclosure. Compared with the system using the voltage equalization module 30 according to the embodiment of the present disclosure, the system using the conventional bidirectional DC/DC module will obviously have a larger product volume, greater loss, and higher costs.

Therefore, in the embodiment of the present disclosure, the equalization and protection between the battery packs 20 in parallel can be effectively and quickly realized by arranging the voltage equalization modules 30 connected in series, which may also be realized for new batteries and retired batteries independent of the output voltage of each battery pack.

In the embodiment of the present disclosure, the voltages, the currents, and the number n of the battery packs are all arbitrary values, and any voltage value, current value, and number can be calculated in the above manner, which are not limited to 180 battery packs. In addition, the number n of the battery packs in the embodiment of the present disclosure can be infinitely large, so as to meet the requirement for expansion of a high capacity of the battery.

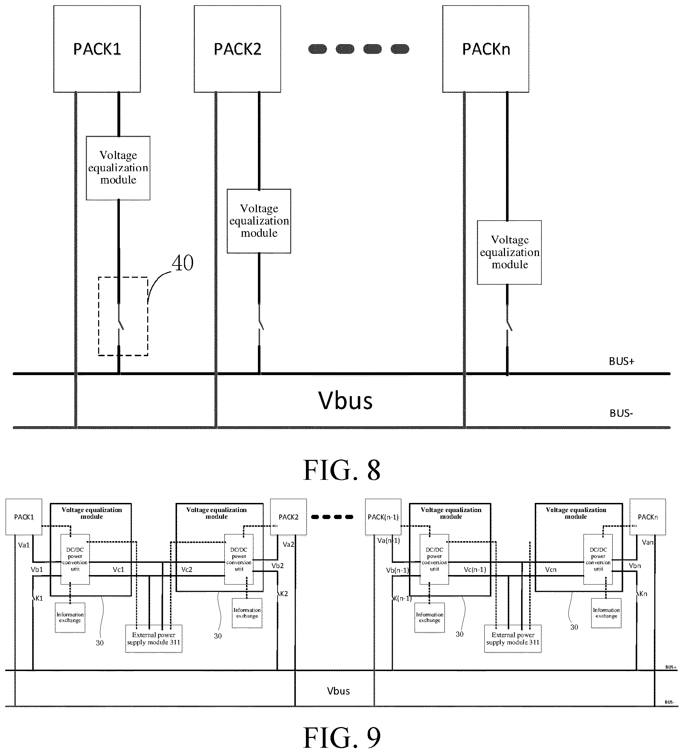

In practical application, for fault isolation and electrical safety, a disconnecting device may be connected in series in the branch circuit, which may be separately disconnected when a single pack fails or needs to be disconnected manually. As shown in FIG. 8, the charging and discharging system 1 of the embodiment of the present disclosure further includes multiple switch modules 40. The number of the switch modules 40 is the same as the number of the voltage equalization modules 30. The switch modules 40 are connected in series with the voltage equalization modules 30 in a one-to-one correspondence, so that the related circuits can be turned on and off by controlling the switch modules 40. In an embodiment, the switch module 40 can be closed only when it is detected that the output voltages of the battery PACK and the voltage equalization module 30 satisfy Vbus = Va1 + Vb1, and the switch module 40 may be a contactor, a semiconductor switch, or the like.

In the embodiment, as shown in FIG. 9, the charging and discharging system 1 further includes at least one external power supply module 311 for supplying power to the voltage equalization module 30. The at least one external power supply module 311 is connected with the at least one voltage equalization module 30, and is configured to provide a DC supply signal for the voltage equalization module 30. That is to say, the voltage equalization module 30 is powered by a separate power supply module 50, such as a battery pack, so that the power supply of the voltage equalization module 30 is independent of the voltage of the main circuit. Supplying power separately may help reduce a voltage level, facilitate device model selection, and further reduce the cost of a material for a flexible voltage adjustment unit.

In the embodiment, one or more external power supply modules 311 may be arranged. The external power supply module 311 may be a battery pack, such as a battery pack. That is to say, the voltage equalization module 30 not only can be powered by the battery pack connected in series with the voltage equalization module, but also can be powered by a separate external power supply module 311 such as a battery pack. In addition, the battery pack not only can supply power in a one-to-one manner, but also can be arranged for adjacent voltage equalization modules 30, or only one battery pack may be used to supply power to all of the voltage equalization modules 30.

For example, when one external power supply module 311 is arranged, the external power supply module 311 is connected with all of the voltage equalization modules 30, and is configured to provide a DC supply signal for each voltage equalization module 30.

Alternatively, when multiple external power supply modules 311 are arranged, the multiple external power supply module 311 are connected with all of the voltage equalization modules 30 in a one-to-one correspondence, and are configured to provide a DC supply signal for the voltage equalization modules 30. That is to say, each voltage equalization module 30 is correspondingly provided with one external power supply module 311 to realize one-to-one power supply.

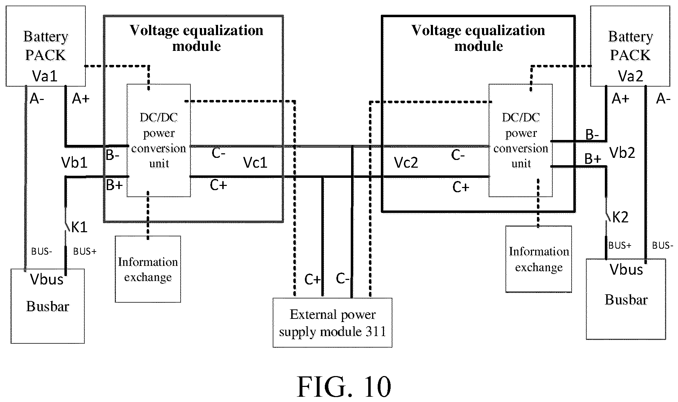

Alternatively, one of the multiple external power supply modules 311 is connected with two adjacent voltage equalization modules 3, and is configured to provide DC supply signals for the two adjacent voltage equalization modules 30, as shown in FIG. 9 and FIG. 10.

Alternatively, the multiple external power supply module 311 may also be used to jointly supply power to one voltage equalization module 30. For example, a battery pack of a branch where the voltage equalization module 30 is located and a correspondingly arranged external battery pack jointly supply power to the voltage equalization module 30.

In general, in the charging and discharging system 1 of the embodiment of the present disclosure, the voltage equalization modules 30 are connected in series, which not only can effectively resolve the problems of safe parallel connection and circulating currents of the batteries connected in parallel, but also can improve the reliability and stability of the system and effectively increase the life of the system. In addition, the output voltage of the voltage equalization module 30 is flexible and controllable. Compared with the solution 2 in the related art, the output power of the voltage equalization module 30 of the present disclosure can be reduced from the original 150 KW to 1.25 KW. That is to say, the power is reduced to 0.8% of the original power and is smaller, the volume can be smaller, and the cost is also reduced, which facilitates mass application and mounting, and realize portable and flexible application. Moreover, a protector connected in parallel is externally mounted on the main circuit of the system. Only a positive electrode or a negative electrode is connected with the main circuit, which will not lose the power of the entire system. The system efficiency can be increased from 98% to 99%, and therefore the system has obvious advantages in improving system efficiency.

In the description of this specification, description of reference terms such as "specific embodiments", or "a specific example", means including specific features, structures, materials, or features described in the embodiment or example in at least one embodiment or example of the present disclosure. In this specification, schematic descriptions of the foregoing terms necessarily of the necessarily directed at a same embodiment or example.

Although the embodiments of the present disclosure have been shown and described, persons of ordinary skill in the art should understand that various changes, modifications, replacements and variations may be made to the embodiments without departing from the principles and spirit of the present disclosure, and the scope of the present disclosure is as defined by the appended claims and their equivalents.

**Claims**

1. A charging and discharging system, comprising:

   a plurality of battery packs, connected in parallel; and
   at least one voltage equalization module, wherein
   each of a subset of the battery packs is connected in series with the at least one voltage equalization module; and the at least one voltage equalization module is configured to adjust, to a target voltage, an output voltage of the corresponding battery pack and the at least one voltage equalization module that are connected in series.

2. The charging and discharging system according to claim 1, wherein the voltage equalization module is a boost-buck equalization module; and
   the boost-buck equalization module is connected in series with the battery pack, and is configured to increase or decrease, to the target voltage, an output voltage of the battery pack and the boost-buck equalization module that are connected in series.

3. The charging and discharging system according to claim 2, wherein the boost-buck equalization module comprises a boost-buck regulation unit; and the boost-buck regulation unit further comprises:

   a first conversion subunit, configured to convert a direct current (DC) supply signal to an alternating current (AC) signal;
   a transformer subunit, comprising a primary side coil and a secondary side coil, wherein the primary side coil of the transformer subunit is connected with an output terminal of the first conversion subunit, and is configured to transmit the AC signal;
a second conversion subunit, wherein an input terminal of the second conversion subunit is connected with the secondary side coil of the transformer subunit, and is configured to convert the AC signal to a first DC signal; and a voltage value of the first DC signal is equal to an absolute value of a voltage difference between the target voltage and the output voltage of the battery pack; and
a third conversion subunit, wherein an input terminal of the third conversion subunit is connected with an output terminal of the second conversion subunit; the third conversion subunit is configured to convert the first DC signal to a second DC signal; an output terminal of the third conversion subunit outputs the second DC signal; and a voltage value of the second DC signal is equal to a voltage value of the first DC signal, or the voltage value of the second DC signal is a negative value of the voltage value of the first DC signal.

4. The charging and discharging system according to claim 1, wherein the voltage equalization module is a boost equalization module; and
the boost equalization module is connected in series with the battery pack, and is configured to increase, to the target voltage, an output voltage of the battery pack and the boost equalization module that are connected in series.

5. The charging and discharging system according to claim 1, wherein the voltage equalization module is a buck equalization module; and
the buck equalization module is connected in series with the battery pack, and is configured to decrease, to the target voltage, an output voltage of the battery pack and the buck equalization module that are connected in series.

6. The charging and discharging system according to any of claims 1 to 5, further comprising at least one external power supply module, wherein the at least one external power supply module is connected with the at least one voltage equalization module, and is configured to provide a DC supply signal for the voltage equalization module.

7. The charging and discharging system according to claim 1, wherein the battery pack is connected in parallel with a busbar.

8. The charging and discharging system according to claim 7, wherein

N battery packs are arranged; N voltage equalization modules are arranged;
the N battery packs are connected in series with the N voltage equalization modules in a one-to-one correspondence, so that the output voltage of each of the battery packs and each of the voltage equalization modules that are connected in series is equal to the target voltage; and
the target voltage is a busbar voltage.

9. The charging and discharging system according to claim 7, wherein N battery packs are arranged; N-1 voltage equalization modules are arranged;

the N-1 battery packs are connected in series with the N-1 voltage equalization modules in a one-to-one correspondence, so that the output voltage of each of the battery packs and a corresponding one of the voltage equalization modules that are connected in series is equal to the target voltage; and
the target voltage is equal to the output voltage of the battery pack that is not connected in series with the voltage equalization module.

10. The charging and discharging system according to claim 1, wherein the voltage equalization module comprises:

a voltage regulation unit, being a boost-buck regulation unit, a boost regulation unit, or a buck regulation unit;
a communication unit, connected with battery management units of the plurality of battery packs and configured to acquire battery parameters of each of the battery packs;
a current detection unit, configured to detect an output current of the voltage equalization unit;
a voltage detection unit, configured to detect an output voltage of the voltage equalization unit; and
a control unit, respectively connected with the communication unit, the current detection unit, and the voltage detection unit and configured to control the voltage regulation unit according to the battery parameters, the output current, and the output voltage, so that the output voltage of the battery pack and the voltage equalization module that are connected in series is equal to the target voltage.

11. The charging and discharging system according to claim 1, further comprising:

a plurality of switch modules, connected in series with the voltage equalization modules in a one-to-one correspondence.

FIG. 1

FIG. 2

FIG. 3

FIG. 4

FIG. 5

FIG. 6

FIG. 7

FIG. 8

FIG. 9

FIG. 10

## INTERNATIONAL SEARCH REPORT

| International application No. |
|---|
| **PCT/CN2021/103509** |

**A. CLASSIFICATION OF SUBJECT MATTER**

H02J 7/00(2006.01)i

According to International Patent Classification (IPC) or to both national classification and IPC

**B. FIELDS SEARCHED**

Minimum documentation searched (classification system followed by classification symbols)

H02J 7/-, H01M 10/-

Documentation searched other than minimum documentation to the extent that such documents are included in the fields searched

Electronic data base consulted during the international search (name of data base and, where practicable, search terms used)

CNABS, CNTXT, DWPI, SIPOABS, IEEE, CNKI, 电池, 均衡, 升压, 降压, 变压器, 变换, 并联, battery, cell, balance, boost, step, buck, transformer, convert, parallel

**C. DOCUMENTS CONSIDERED TO BE RELEVANT**

| Category* | Citation of document, with indication, where appropriate, of the relevant passages | Relevant to claim No. |
|---|---|---|
| PX | CN 212588110 U (BYD COMPANY LTD.) 23 February 2021 (2021-02-23) claims 1-11 | 1-11 |
| PX | CN 213027469 U (BYD COMPANY LTD.) 20 April 2021 (2021-04-20) description, paragraphs [0036]-[0106], and figures 3-6 | 1, 2, 4-8, 10 |
| PX | CN 112993418 A (BYD COMPANY LTD.) 18 June 2021 (2021-06-18) description, paragraphs [0035]-[0098], and figures 1-11 | 1, 4, 7-10 |
| E | CN 113285129 A (XIAMEN HAITAI NEW ENERGY TECHNOLOGY CO., LTD.) 20 August 2021 (2021-08-20) description, paragraphs [0027]-[0035], and figures 1-5 | 1-2, 4-8 |
| X | CN 108336783 A (BEIJING HYPERSTRONG TECHNOLOGY CO., LTD.) 27 July 2018 (2018-07-27) description, paragraphs [0024]-[0123], and figures 1-6 | 1-2, 4-5, 7-9, 11 |
| Y | CN 108336783 A (BEIJING HYPERSTRONG TECHNOLOGY CO., LTD.) 27 July 2018 (2018-07-27) description, paragraphs [0024]-[0123], and figures 1-6 | 6, 10 |
| Y | CN 110239396 A (SHANDONG UNIVERSITY) 17 September 2019 (2019-09-17) description paragraphs [0042]-[0090], figures 1-3(c) | 6, 10 |

☑ Further documents are listed in the continuation of Box C.    ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **13 September 2021** | **27 September 2021** |

| Name and mailing address of the ISA/CN | Authorized officer |
|---|---|
| **China National Intellectual Property Administration (ISA/ CN)** **No. 6, Xitucheng Road, Jimenqiao, Haidian District, Beijing 100088 China** | |
| Facsimile No. **(86-10)62019451** | Telephone No. |

Form PCT/ISA/210 (second sheet) (January 2015)

## INTERNATIONAL SEARCH REPORT

| International application No. |
|---|
| **PCT/CN2021/103509** |

**C.      DOCUMENTS CONSIDERED TO BE RELEVANT**

| Category* | Citation of document, with indication, where appropriate, of the relevant passages | Relevant to claim No. |
|---|---|---|
| X | CN 106712168 A (SOUTH CHINA UNIVERSITY OF TECHNOLOGY) 24 May 2017 (2017-05-24) <br> description, paragraphs [0023]-[0029], and figures 1-5 | 1-2, 4-5, 7-9, 11 |
| X | CN 207939219 U (SHANGHAI AEROSPACE POWER TECHNOLOGY CO., LTD.) 02 October 2018 (2018-10-02) <br> description, paragraphs [0031]-[0045], and figures 1-3 | 1-2, 4-5, 7-9, 11 |
| A | EP 1265336 B1 (SAFT FINANCE SARL) 09 January 2019 (2019-01-09) <br> entire document | 1-11 |

Form PCT/ISA/210 (second sheet) (January 2015)

INTERNATIONAL SEARCH REPORT
Information on patent family members

International application No.

**PCT/CN2021/103509**

| Patent document cited in search report | | | Publication date (day/month/year) | Patent family member(s) | | | Publication date (day/month/year) |
|---|---|---|---|---|---|---|---|
| CN | 212588110 | U | 23 February 2021 | None | | | |
| CN | 213027469 | U | 20 April 2021 | None | | | |
| CN | 112993418 | A | 18 June 2021 | None | | | |
| CN | 113285129 | A | 20 August 2021 | None | | | |
| CN | 108336783 | A | 27 July 2018 | CN | 108336783 | B | 09 October 2020 |
| CN | 110239396 | A | 17 September 2019 | None | | | |
| CN | 106712168 | A | 24 May 2017 | None | | | |
| CN | 207939219 | U | 02 October 2018 | None | | | |
| EP | 1265336 | B1 | 09 January 2019 | FR | 2825842 | B1 | 03 October 2003 |
| | | | | FR | 2825842 | A1 | 13 December 2002 |
| | | | | EP | 1265336 | A3 | 13 February 2008 |
| | | | | JP | 2003009414 | A | 10 January 2003 |
| | | | | EP | 1265336 | A2 | 11 December 2002 |
| | | | | US | 6750631 | B2 | 15 June 2004 |
| | | | | US | 2002195994 | A1 | 26 December 2002 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202021264961